# EUROPEAN PATENT APPLICATION

(11) **EP 4 629 291 A1**
(43) Date of publication of application: **08.10.2025**
(21) Application number: 24824379.2
(22) Date of filing: 13.03.2024
(51) Int. Cl.: H01L 23/64, H10N 97/00

(54) **CAPACITOR STRUCTURE AND MANUFACTURING METHOD FOR CAPACITOR STRUCTURE**

(30) Priority: 22.02.2024 CN 202410198437
(71) Applicant: Suzhou Suna Opto-Electronics Co., Ltd, Suzhou, Jiangsu 215000 (CN)
(72) Inventor: FEI, Xiaobin, Suzhou, Jiangsu 215000 (CN); MULLER, Charles, 14510 Houlgate (FR); HUANG, Yuyang, Suzhou, Jiangsu 215000 (CN); WU, Haihua, Suzhou, Jiangsu 215000 (CN)
(74) Representative: Proi World Intellectual Property GmbH
(86) International application number: PCT/CN2024/081448
(87) International publication number: WO 2025/175607

(57) **Abstract**

The present invention discloses a capacitor structure and a method for fabricating the same. The capacitor structure comprises a substrate with passivation regions arranged at intervals, as well as a first conductive layer, a first dielectric layer, a second conductive layer, a second dielectric layer and a third conductive layer formed in sequence on a surface of the substrate, wherein the second conductive layer is connected to the substrate in a non-passivation region between adjacent passivation regions to form a first electrode layer. The first conductive layer is electrically connected to the third conductive layer to form a second electrode layer. The first dielectric layer is connected to the second dielectric layer and contacts the passivation regions to isolate the first electrode layer from the second electrode layer; a first electrode is formed on a surface of the substrate away from the passivation regions; and a second electrode is formed on a surface of the third conductive layer. According to the present invention, the capacitor structure increases the contact area between the dielectric layer and the electrode layer, while avoiding the traditional method of using an electrode protection ring to extract one of the electrode layers, which greatly reduces the ESR and ESL.

## Description

The present invention claims the priority of Chinese Invention No. 2024101984374 , filed in Chinese Patent Office on February 22, 2024, and entitled "Capacitor Structure and Method for Fabricating the Same ", the entire contents of which are herein incorporated by reference.

### Technical Field

The present invention relates to a field of semiconductor, and more particularly to a capacitor structure and a method for fabricating the same.

### Background Art

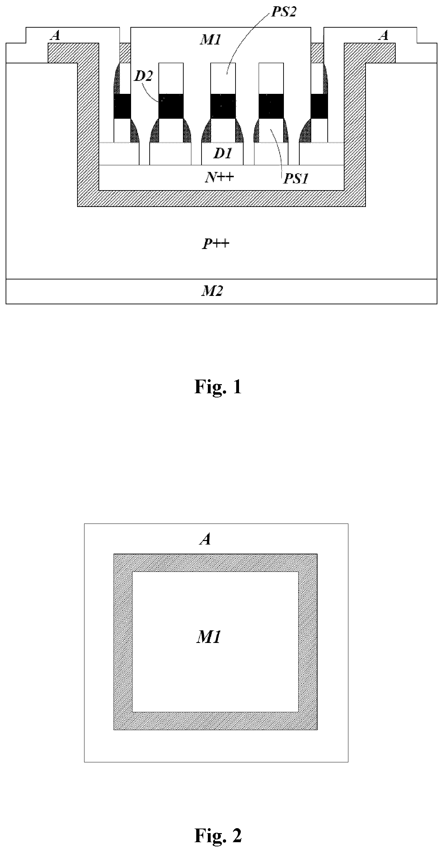

As shown in Fig.1 and Fig.2, for the heterogenous electrode extraction of multi-layer deep trench capacitor (DTC), the current way is to extract an electrode protection ring A (which is a seal ring) at an edge of the chip. The fundamental function of the electrode protection ring A (seal ring) is to define the chip area and prevent mechanical damage to the chip during dicing process. The polycrystalline silicon layer (PS1) is connected to a chip substrate and the lower electrode (M2) on the back of the chip via an electrode protection ring A (seal ring) as an intermediary. The central area of the chip extracts directly to the N++ layer and the electrode of the polycrystalline silicon layer (PS2) to the front to form the upper electrode (M1). The upper electrode (M1) and the electrode protection ring A (seal ring) are ultimately in the same plane. Of these, the shaded areas in Fig.1 and Fig.2 are both insulation layers.

In order to directly draw out the N++ layer and the polycrystalline silicon layer (PS2) in the central area on the front of the chip, a plurality of through holes need to be provided in the polycrystalline silicon layer (PS1) and the dielectric layer (D1) and the dielectric layer (D2). However, this arrangement greatly reduces the contact area between the polycrystalline silicon layer (PS1) and the polycrystalline silicon layer (PS2) as the electrode layer and the dielectric layer (D1) and the dielectric layer (D2), which affects the capacitance density.

Moreover, due to the presence of electrode protection ring A, there will be a large ESR (equivalent series resistance) and ESL (equivalent series inductance). Due to the presence of electrode protection ring A, it will also occupy the surface area on the front of the chip, sacrificing part of the capacitance density and electrode protection ring A is easily misaligned during wire bonding, which can cause the electrode protection ring A(seal ring) to short with the upper electrode (M1) on the front of the chip, resulting in a short circuit between the upper electrode (M1) and the lower electrode (M2) and causing the device to fail.

The disclosure of information in this background art section is solely intended to increase the understanding of the general background of the invention and should not be regarded as an admission or any form of implication that the information constitutes prior art that is already known to those skilled in the art.

### Summary of the Invention

The object of the present invention is to provide a capacitor structure and a method for fabricating the same. The way in which the adjacent dielectric layers are connected increases the contact area between the dielectric layers (a first dielectric layer and a second dielectric layer) and the electrode layers (a first conductive layer and a third conductive layer, a second conductive layer and a substrate), while at the same time avoiding the use of an electrode protection ring to extract one of the electrode layers, which greatly reduces the ESR (equivalent series resistance) and ESL (equivalent series inductance). In addition, the different electrodes are located on different surfaces, which also prevents a short circuit during subsequent wire bonding that causes device failure.

To achieve the foregoing objects, the present invention provides a capacitor structure comprising a substrate with passivation regions arranged at intervals, as well as a first conductive layer, a first dielectric layer, a second conductive layer, a second dielectric layer and a third conductive layer formed in sequence on a surface of the substrate. The second conductive layer is connected to the substrate in a non-passivation region between adjacent passivation regions to form a first electrode layer; the first conductive layer is electrically connected to the third conductive layer to form a second electrode layer; the first dielectric layer is connected to the second dielectric layer and contacts the passivation region to isolate the first electrode layer from the second electrode layer; a first electrode is formed on a surface of the substrate away from the passivation regions; and a second electrode is formed on a surface of the third conductive layer.

In one or more embodiments of the present invention, the substrate comprises a first region, a second region that surrounds the first region, and a third region that surrounds the second region. The non-passivation region between the adjacent passivation regions is located in the first region, the second conductive layer is connected to the substrate in the first region, the first dielectric layer is in contact with the passivation regions in the first region. The first dielectric layer is connected to the second dielectric layer in the second region; and the first conductive layer is connected to the third conductive layer in the third region.

In one or more embodiments of the present invention, the substrate comprises a first surface and a second surface disposed opposed to each other. The passivation regions extend from the first surface to the second surface, the first surface has trenches formed in the passivation region, and the trenches have a plurality of discrete columnar structures formed by portions of the substrate.

In one or more embodiments of the present invention, the first conductive layer, the first dielectric layer, the second conductive layer, the second dielectric layer, and the third conductive layer cover or partially cover the first surface of the substrate, inner sidewalls of the trenches, and outer surfaces of the columnar structures.

In one or more embodiments of the present invention, the first conductive layer is formed on the first surface of the substrate, on inner sidewalls of the trenches, and on outer surfaces of the columnar structures. The first conductive layer is provided with a first window that corresponds to the non-passivation region, and the first window exposes the substrate in the non-passivation region and a portion of the substrate in the passivation region.

In one or more embodiments of the present invention, the first dielectric layer is formed on a surface of the first conductive layer and contacts the passivation region at the first window to isolate the substrate from the first conductive layer. The first window exposes a portion of the substrate in the non-passivation region; wherein a second window is provided in the first dielectric layer, and the second window exposes a portion of the first conductive layer.

In one or more embodiments of the present invention, the second window is disposed at the first surface at an edge of the substrate, and the second window is filled with conductive material that is connected to the first conductive layer.

In one or more embodiments of the present invention, the second conductive layer is formed on a surface of the first dielectric layer and in the first window to be in connection with the substrate to form the first electrode layer. A third window is provided in the second conductive layer, and the third window exposes a portion of the first dielectric layer.

In one or more embodiments of the present invention, the third window is disposed at the first surface at an edge of the substrate and is surrounded by the second window.

In one or more embodiments of the present invention, the second dielectric layer is formed on the surface of the second conductive layer and is connected to the first dielectric layer at the third window to isolate the first conductive layer from the second conductive layer, and a fourth window corresponding to the second window is provided in the second dielectric layer.

In one or more embodiments of the present invention, the third conductive layer is formed on surface of the second dielectric layer and in the fourth window, and is connected to the first conductive layer via the conductive material in the second window to form the second electrode layer.

In one or more embodiments of the present invention, the substrate is a heavily doped P-type substrate.

In one or more embodiments of the present invention, the passivation region is a N-type diffusion region.

In one or more embodiments of the present invention, the first conductive layer is a heavily doped N-type polycrystalline silicon layer or ALD-deposited TiN.

In one or more embodiments of the present invention, the first dielectric layer is SiN, SiO₂, ONO or a high K material.

In one or more embodiments of the present invention, the second conductive layer is a polycrystalline silicon layer or ALD-deposited TiN.

In one or more embodiments of the present invention, the second dielectric layer is SiN, SiO₂, ONO or high K material.

In one or more embodiments of the present invention, the third conductive layer is a polycrystalline silicon layer or ALD-deposited TiN.

The present invention also provides a method for fabricating a capacitor structure, which comprises the following steps: providing a substrate having a first surface and a second surface opposed to each other; forming passivation regions disposed at intervals on the first surface of the substrate, non-passivation region that exposing the substrate between adjacent passivation regions; forming trenches in the passivation regions of the first surface, the trenches having a plurality of discrete columnar structures formed from portions of the substrate; forming a first conductive layer on the first surface of the substrate, on inner sidewalls of the trenches and on outer surfaces of the columnar structures, the first conductive layer exposing a portion of the substrate in the non-passivation region of the substrate; forming a first dielectric layer on a surface of the first conductive layer, the first dielectric layer contacting the passivation region in the non-passivation region, the first dielectric layer and the first conductive layer acting together to isolate the first conductive layer from the substrate; forming a second conductive layer on a surface of the first dielectric layer that is in contact with the substrate; forming a second dielectric layer on a surface of the second conductive layer that is in contact with the first dielectric layer, the second dielectric layer and the first dielectric layer acting together to isolate the second conductive layer from the first conductive layer; forming a third conductive layer on a surface of the second dielectric layer that is in contact with the second conductive layer; forming a first electrode on the second surface of the substrate; and forming a second electrode on a surface of the third conductive layer.

In one or more embodiments of the present invention, a first dielectric layer in contact with the passivation regions is formed on the surface of the first conductive layer, further comprising: opening a first window corresponding to the non-passivation region in the first conductive layer, the first window exposing the substrate of the non-passivation region and a portion of the substrate of the passivation region; and forming a first dielectric layer on the surface of the first conductive layer, the first dielectric layer contacting the exposed passivation region at the first window to isolate the substrate from the first conductive layer.

In one or more embodiments of the present invention, the method further comprises: opening a second window in the first dielectric layer, and the second window exposes a portion of the first conductive layer; and forming a second conductive layer on the surface of the first dielectric layer and in the first window to connect the substrate.

In one or more embodiments of the present invention, the method further comprises: opening a third window in the second conductive layer, and the third window exposes a portion of the first dielectric layer; and forming a second dielectric layer on the surface of the second conductive layer and in the third window, which is connected to the first dielectric layer, to isolate the first conductive layer from the second conductive layer.

In one or more embodiments of the present invention, the method further comprises: opening a fourth window corresponding to the second window in the second dielectric layer; and forming a third conductive layer on the surface of the second dielectric layer and in the fourth window, and the third conductive layer is connected to the first conductive layer via the conductive material in the second window.

In one or more embodiments of the present invention, the non-passivation region is located in the middle of the substrate and is surrounded by the second window and third window; the second window is located at the first surface at an edge of the substrate; and the third window is located at the first surface at the edge of the substrate and being surrounded by the second window.

Compared to the prior art, by making holes in the second conductive layer, connecting the adjacent first dielectric layer and the second dielectric layer, the capacitor structure and the method for fabricating the capacitor structure of the present invention increase the contact area between the dielectric layers (the first dielectric layer, the second dielectric layer) and the first electrode layer (the second conductive layer and the substrate) as well as and the second electrode layer (the first conductive layer and the third conductive layer), and the capacitance density is also increased.

According to the capacitor structure and the method for fabricating the same of the present invention, only the first conductive layer and the third conductive layer are extracted as the second electrode layer, and the second conductive layer is extracted directly through the substrate to form the first electrode layer, which avoids the use of an electrode protection ring for the extraction of the first electrode layer, effectively increases the area of the second electrode, and improves the capacitance density.

According to the capacitor structure and the method for fabricating the capacitor structure of the present invention, the first electrode and the second electrode are formed on separate surfaces, which will not cause the problem of a short circuit between the electrodes during subsequent wire bonding and thus cause the device to fail.

The capacitor structure and the method for fabricating the capacitor structure of the present invention optimize the flow path of the current through structural design, thereby greatly reduce the ESR (equivalent series resistance) and ESL (equivalent series inductance).

### Brief Description of the Drawings

In order to more clearly illustrate the technical solutions of the embodiments of the present invention, the accompanying drawings to be used in the embodiments will be briefly introduced below, and it should be understood that the following accompanying drawings only show certain embodiments of the present invention, and therefore should not be regarded as a limitation of the scope, and that, for the person of ordinary skill in the field, other relevant accompanying drawings can be obtained based on the drawings without creative labor.
FIG. 1 is a section view of a capacitor structure in the prior art.
FIG. 2 is a top view of a capacitor structure in the prior art.
FIG. 3 is a section view of a capacitor structure in an embodiment of the present invention.
FIG. 4 is a top view of a capacitor structure in an embodiment of the present invention.
FIG. 5a-5j are schematic diagrams of the process steps of a method for fabricating a capacitor structure in an embodiment of the present invention.

### Detailed Description of the Invention

In order to make the purpose, technical solutions and advantages of the embodiments of the present invention clearer, the technical solutions in the embodiments of the present invention will be described clearly and completely in the following in conjunction with the accompanying drawings in the embodiments of the present invention, and it is clear that the described embodiments are a part of the embodiments of the present invention and not all of the embodiments. The components of embodiments of the present invention generally described and illustrated in the accompanying drawings herein may be arranged and designed in a variety of different configurations.

Accordingly, the following detailed description of the embodiments of the present invention provided in the accompanying drawings is not intended to limit the scope of the present invention for which protection is claimed, but merely indicates selected embodiments of the present invention. Based on the embodiments in this invention, all other embodiments obtained by a person of ordinary skill in the art without creative labor fall within the scope of protection of this invention.

It should be noted that similar symbols and letters denote similar items in the following drawings, so that once an item is defined in one drawing, it does not need to be further defined and explained in subsequent drawings. Also, in the description of the present invention, the terms 'first', 'second', etc., are used only to distinguish descriptions and are not to be understood as indicating or implying relative importance.

It is to be noted that, in this document, relational terms such as first and second are used only to distinguish one entity or operation from another, and do not necessarily require or imply the existence of any such actual relationship or order between those entities or operations. Further, the terms 'including', 'comprising', or any other variant thereof, are intended to cover nonexclusive inclusion, such that a process, method, article, or apparatus comprising a set of elements includes not only those elements, but also other elements not expressly listed, or other elements that are not expressly listed for the purpose of such a process, method, article or apparatus, elements, or also includes elements that are inherent to such process, method, article or apparatus. Without further limitation, the fact that an element is defined by the phrase 'includes a ...' does not preclude the existence of additional identical elements in the process, method, article or apparatus that includes said element.

In the description of this invention, it should be noted that the terms 'upper', 'lower', 'inner', 'outer', etc., are not intended to be used to describe the invention or to simplify the description.

The indicated orientation or positional relationship is based on the orientation or positional relationship shown in the accompanying drawings, or the orientation or positional relationship in which the product of the invention is customarily placed in use, and is only for the purpose of facilitating the description of the invention and simplifying the description, and is not intended to indicate or imply that the device or element referred to must have a specific orientation, be constructed and operated with a specific orientation, and therefore is not to be construed as a limitation of the present invention.

In the description of the present invention, it should also be noted that, unless otherwise expressly specified and limited, the terms 'setting' and 'connecting' are to be understood in a broad sense, e.g., as a fixed connection, a detachable connection or a connection in one piece; a mechanical connection or an electrical connection; a direct connection or an indirect connection through an intermediate medium; or a connection within two elements. The connection may be mechanical or electrical; it may be direct or indirect through an intermediate medium, or it may be a connection within the two elements. For a person of ordinary skill in the art, the specific meaning of the above terms in the present application may be understood in specific cases.

As mentioned in the background technology, the existing multi-layer deep trench capacitor (DTC) usually has an electrode protection ring A (seal ring) at an edge of the chip. The electrode protection ring A (seal ring) is used as an intermediary to connect a polycrystalline silicon layer (PS1) with the chip substrate and the lower electrode (M2) on the back of the chip. The central area of the chip directly extracts the electrodes of the N++ layer and a polycrystalline silicon layer (PS2) to form the upper electrode (M1) on the front side, and the upper electrode (M1) and the electrode protection ring A (seal ring) are ultimately in the same plane.

However, this design has many disadvantages. For example, in order to directly draw out the N++ layer and the polycrystalline silicon layer (PS2) in the central area on the front of the chip, a plurality of through holes need to be provided in the polycrystalline silicon layer (PS1), the dielectric layer (D1) and the dielectric layer (D2). However, this arrangement greatly reduces the contact area between the polycrystalline silicon layer (PS1) and the polycrystalline silicon layer (PS2) as the electrode layer and the dielectric layer (D1) and the dielectric layer (D2), which affects the capacitance density. Moreover, due to the presence of electrode protection ring A, there will be a large ESR (equivalent series resistance) and ESL (equivalent series inductance). Due to the presence of electrode protection ring A, it will also occupy the surface area on the front of the chip, sacrificing part of the capacitance density; and electrode protection ring A is easily misaligned during wire bonding, which can cause the electrode protection ring A (seal ring) to short with the upper electrode (M1) on the front of the chip, resulting in a short circuit between the upper electrode (M1) and the lower electrode (M2) and causing the device to fail.

Based on this, the present invention provides a capacitor structure and a method for manufacturing the same. The way in which the adjacent dielectric layers are connected increases the contact area between the dielectric layers (first and second dielectric layers) and the electrode layers (first conductive layer and third conductive layer, second conductive layer and substrate), while at the same time avoiding the use of an electrode protection ring to extract one of the electrode layers, which greatly reduces the ESR (equivalent series resistance) and ESL (equivalent series inductance). In addition, the different electrodes are located on different surfaces, which also prevents a short circuit during subsequent wire bonding and subsequent device failure.

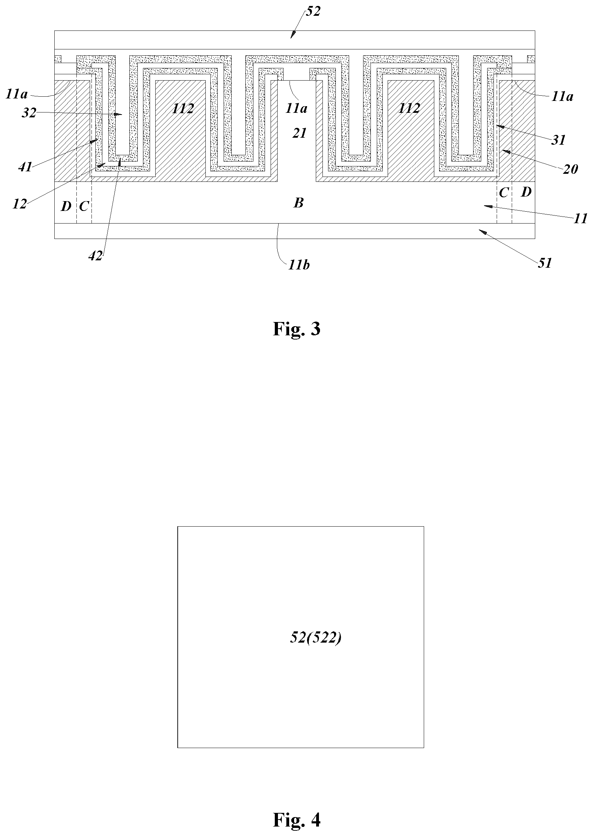

Referring to Fig.3, a capacitor structure in an embodiment of the present invention comprises a substrate with passivation regions 20 arranged at intervals, as well as a first conductive layer 31, a first dielectric layer 41, a second conductive layer 12, a second dielectric layer 42 and a third conductive layer 32 formed in sequence on a surface of the substrate. A first electrode 51 formed on a surface of the substrate 11 away from the passivation regions 20; and a second electrode 52 formed on a surface of the third conductive layer 32. The second conductive layer 12 is connected to the substrate 11 in a non-passivation region 21 between adjacent two passivation regions 20 to form a first electrode layer. The first conductive layer 31 is connected to the third conductive layer 32 to form a second electrode layer. The first dielectric layer 41 is connected to the second dielectric layer 42 and contacts the passivation regions 20 to isolate the first electrode layer from the second electrode layer.

In the above-mentioned embodiment, by connecting the adjacent first dielectric layer 41 and the second dielectric layer 42, the contact area between the first dielectric layer 41, the second dielectric layer 42 and the first electrode layer (the second conductive layer 12 and the substrate 11) and the second electrode layer (the first conductive layer 31 and the third conductive layer 32) is increased, thereby increasing the capacitance density. The first electrode 51 and the second electrode 52 are formed on different surfaces, which also prevents a short circuit between the electrodes during subsequent wire bonding, thus preventing device failure.

In one preferred embodiment, the substrate 11 comprises a first region B, a second region C and a third region D. The first region B is located in the middle of the substrate 11. The second region C is located at an edge of the substrate 11 and surrounds the first region B. The third region D is located at an outermost edge of the substrate 11 and surrounds the second region C. The non-passivation region between adjacent passivation regions 20 is disposed in the first region B. The second conductive layer 12 is connected to the substrate 11 in the first region B. The first dielectric layer 41 is in contact with the passivation region 20 in the first region B, and preferably the two connection positions are in contact. The first dielectric layer 41 is connected to the second dielectric layer 42 in the second region C. The first conductive layer 31 is connected to the third conductive layer 32 in the third region D.

The first electrode 51 completely covers the first region B, the second region C and the third region D on the side of the substrate 11 that is away from the passivation regions 20. As shown in Fig. 4, the second electrode 52 completely covers the first region B, the second region C and the third region D on the third conductive layer 32.

In the above embodiment, the direct electrode extracting the second conductive layer 31 through the substrate 11 avoids the use of a traditional electrode protection ring for the extraction of the electrode layer, so that the coverage area of the second electrode 52 is the same as that of the first electrode 51, which effectively increases the area of the second electrode 52, increases the capacitance density, and optimizes the flow path of the electric current, thereby substantially reducing the ESR and ESL.

In order to further improve the contact area between the dielectric layers (first dielectric layer 41, second dielectric layer 42) and the electrode layers (first electrode layer, second electrode layer), in the preferred embodiment of the present invention, trenches may be formed on the surface of one side of the substrate 11, and the trenches are located in the passivation region 20. The first conductive layer 31, the first dielectric layer 41, the second conductive layer 12, the second dielectric layer 42, and the third conductive layer 32 cover or partially cover the side of the substrate 11 on which the trenches are formed.

Referring to Fig.3, in an exemplary embodiment, the substrate 11 has a first surface 11a and a second surface 11b disposed opposite to each other. The passivation regions 20 extend from the first surface 11a to the second surface 11b. The passivation regions 20 are preferably N-type diffusion regions, obtained by N-type diffusion of the substrate 11. There is a non-passivation region 21 between adjacent passivation regions 20. The non-passivation region 21 may be formed by masking with a mask during N-type diffusion of the substrate 11.

The trenches 111 are formed on the first surface 11a of the substrate 11 within the passivation regions 20. The trenches 111 have a plurality of discrete columnar structures 112 formed by portions of the substrate 11. The plurality of columnar structures 112 are disposed in an array. The plurality of columnar structures 112 are preferably cylindrical. In the case where the number of columnar structures 112 is the same, the use of an elongated grid structure allows the spacing between adjacent columnar structures 112 to be maximized, accommodating more dielectric layers and increasing the electrical capacity. The substrate 11 is preferably a heavily doped P-type low resistance substrate.

The first conductive layer 31 is formed on the first surface 11a of the substrate 11, the inner sidewalls of the trenches 111, and the outer surfaces of the columnar structures 112. The first conductive layer 31 is an N-type heavily doped polycrystalline silicon layer, which can be obtained by LPCVD growth. Alternatively, the first conductive layer 31 is a TiN layer, which can be obtained by ALD deposition. The first conductive layer 31 is provided with a first window 311 corresponding to the non-passivation region 21, and the projection of the first window 311 in the thickness direction of the substrate 11 partially overlaps with the non-passivation region 21. The first window 311 exposes the substrate 11 of the non-passivation region 21 as well as the substrate 11 of the partially passivation regions 20 surrounding this non-passivation region 21.

The first dielectric layer 41 is formed on the surface of the first conductive layer 31 and is in contact with the exposed passivation region 20 at the first window 311 to isolate the substrate 11 from the first conductive layer 31. The first dielectric layer 41 is obtained by LPCVD growth or ALD deposition. The material of the first dielectric layer 41 may be SiN, SiO₂, ONO, or a high K material.

It is understood that a portion of the non-passivation region 21 of the substrate 11 and a portion of the first window 311 will be filled with the first dielectric layer 41, but there is still some space within the first window 311 and on the non-passivation region 21 that exposes a portion of the substrate 11, so that the subsequent second conductive layer 12 can be connected to the substrate 11 through this space for electrode extraction.

The first dielectric layer 41 is provided with a second window 411. The second window 411 is located on the first surface 11a at the edge of the substrate 11, preferably, within the third region D of the substrate 11. The second window 411 exposes a portion of the first conductive layer 31. The second window 411 is filled with a conductive material that is connected to the first conductive layer 31, also facilitating a subsequent connection setup with the third conductive layer 32.

A second conductive layer 12 is formed on the surface of the first dielectric layer 41 and in the first window 311 to form a first electrode layer in contact with the substrate 11 in the non-passivation area 21. The second conductive layer 12 is preferably a polycrystalline silicon layer and can be formed by LPCVD growth. Alternatively, the second conductive layer 12 is a TiN layer and can be obtained by ALD deposition. A third window 121 is provided in the second conductive layer 12, the third window 121 is located at the first surface 11a of an edge of the substrate 11 and within the area bounded by the second window 411. Preferably, the third window 121 is located in a second region C of the substrate 11. The third window 121 exposes a portion of the first dielectric layer 41.

A second dielectric layer 42 is formed on the surface of the second conductive layer 12 and is connected to the first dielectric layer 41 at the third window 121 to isolate the first conductive layer 31 from the second conductive layer 12, so that the first conductive layer 31 acts as a portion of the second electrode layer and the second conductive layer 12 acts as a portion of the first electrode layer. The second dielectric layer 42 can be obtained by LPCVD growth or ALD deposition. The second dielectric layer 42 may be made of SiN, SiO₂, ONO or high K material.

A fourth window 421 corresponding to the second window 411 is provided on the second dielectric layer 42. The fourth window 421 is also located at the first surface 11a at an edge of substrate 11, and preferably within the third region D of the substrate 11. The fourth window 421 exposes parts of conductive material in the second window 411.

The third conductive layer 32 is formed on the surface of the second dielectric layer 42 and in the fourth window 421, and is connected to the first conductive layer 31 via the conductive material in the second window 411 to form a second electrode layer. The third conductive layer 32 is preferably a polycrystalline silicon layer and can be formed by LPCVD growth. Alternatively, the third conductive layer 32 is a TiN layer and can be obtained by ALD deposition.

The second electrode 52 is formed on the surface of the third conductive layer 32. Both the first electrode 51 and the second electrode 52 can be deposited from metals such as Au, Al-Cu, AlTiNiAg, etc.

Compared to the prior art, by connecting the adjacent first dielectric layer and the second dielectric layer, the capacitor structure of the present invention increases the contact area between the dielectric layers (the first dielectric layer, the second dielectric layer) and the first electrode layer (the second conductive layer and the substrate) as well as the contact area between the dielectric layers and the second electrode layer (the first conductive layer and the third conductive layer), and the capacitance density is also increased.

According to the capacitor structure of the present invention, only the first conductive layer and the third conductive layer are extracted as the second electrode layer, and the second conductive layer is extracted directly through the substrate to form the first electrode layer, which avoids the use of an electrode protection ring for the extraction of the first electrode layer, effectively increases the area of the second electrode, and increases the capacitance density.

According to the capacitor structure of the present invention, the first electrode and the second electrode are formed on separate surfaces, which will not cause the problem of a short circuit between the electrodes during subsequent wire bonding and thus cause the device to fail.

The capacitor structure of the present invention optimizes the flow path of the current through structural design, thereby greatly reduce the ESR (equivalent series resistance) and ESL (equivalent series inductance).

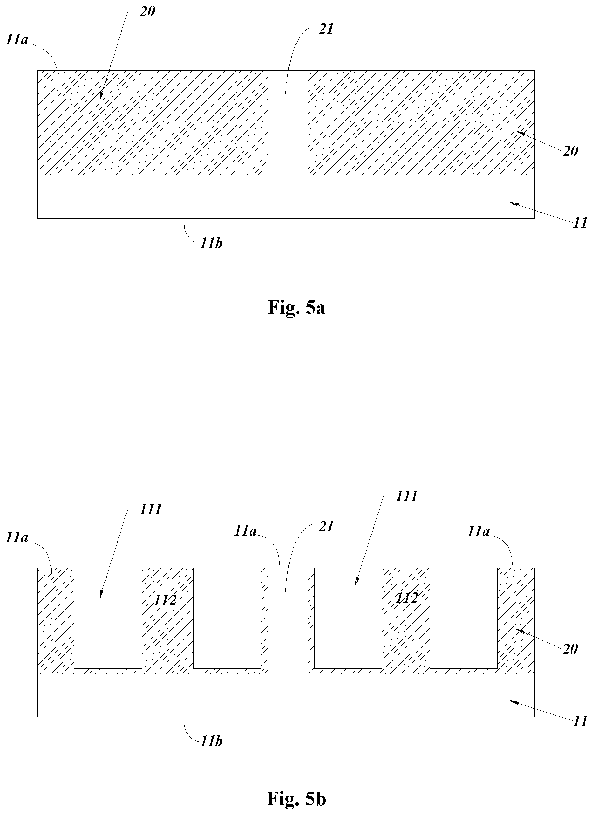

As shown in Figs.5a to 5j, an embodiment of the present invention also provides a method for fabricating the above capacitor structure, which comprises the following steps.

Referring to Fig.5a, a substrate 11 is provided. The substrate 11 is preferably a heavily doped low resistance P-type substrate. The substrate 11 has a first surface 11a and a second surface 11b arranged opposed to each other. The first surface 11a of the substrate 11 is diffused with N-type dopants to form a plurality of passivation regions 20 arranged at intervals (two passivation regions 20 in this embodiment), and non-passivation region 21 is formed between adjacent passivation regions 20. When diffusing, a mask can be used to cover the region that does not need to be diffused (the non-passivation region 21) to form the non-passivation region 21 at the corresponding position on the substrate 11. The substrate 11 is successively divided into a first region B, a second region C, and a third region D from the center to the edge. The second region C is located at an edge of the substrate 11 and surrounds the first region B. The third region D is located at an outermost edge of the substrate 11 and surrounds the second region C.

Referring to Fig.5b, trenches 111 are formed by deep silicon etching within the passivation region 20 on the first surface 11a of the substrate 11. The trenches 111 have a plurality of discrete columnar structures 112 formed by portions of the substrate 11. The plurality of columnar structures 112 are disposed in an array. The plurality of columnar structures 112 are preferably cylindrical. In the case where the number of columnar structures 112 is the same, the use of an elongated grid structure allows the spacing between adjacent columnar structures 112 to be maximized, accommodating more dielectric layers and increasing the electrical capacity.

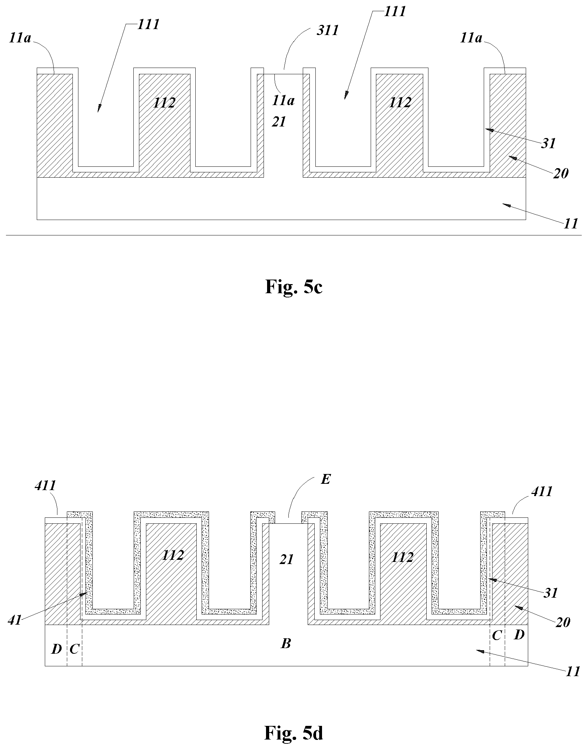

Referring to Fig.5c, a first conductive layer 31 is obtained by LPCVD growth on the first surface 11a of the substrate 11, the inner sidewalls of the trenches 111 and the outer surfaces of the columnar structures 112. The first conductive layer 31 is a heavily doped N-type polycrystalline silicon layer. Alternatively, the first conductive layer 31 is a TiN layer, which can be obtained by ALD deposition. A first window 311 corresponding to the non-passivation region 21 is opened in the first conductive layer 31 by means of reactive ion etching (RIE). The projection of the first window 311 in the thickness direction of the substrate 11 partially overlaps the non-passivation region 21, and the first window 311 exposes the substrate 11 of the non-passivation region 21 and a portion of the substrate 11 of the passivation regions 20 surrounding the non-passivation region 21.

Referring to Fig.5d, the first dielectric layer 41 is deposited on the surface of the first conductive layer 31 by LPCVD or ALD. The material of the first dielectric layer 41 can be SiN, SiO₂, ONO or high K material. It is understood that the first dielectric layer 41 will be deposited to fill the first window 311, contacting the exposed passivation region 20 via the first window 311, and isolating the substrate 11 from the first conductive layer 31. However, in order to enable the second conductive layer 12 to be connected to the substrate 11 without being connected to the first conductive layer 31, the first dielectric layer 41 can be opened by reactive ion etching (RIE) at the first window 311 and in the non-passivation region 21 to form a space E at the first window 311 that only exposes the substrate 11 in the non-passivation region 21. Similarly, in order to enable the third conductive layer 32 to be connected to the first conductive layer 31, a second window 411 is formed by reactive ion etching (RIE) to open holes in the first dielectric layer 41 at the first surface 11a at the edge of the substrate 11. Preferably, the second window 411 is located in the third region D of the substrate 11. The second window 411 exposes a portion of the first conductive layer 31.

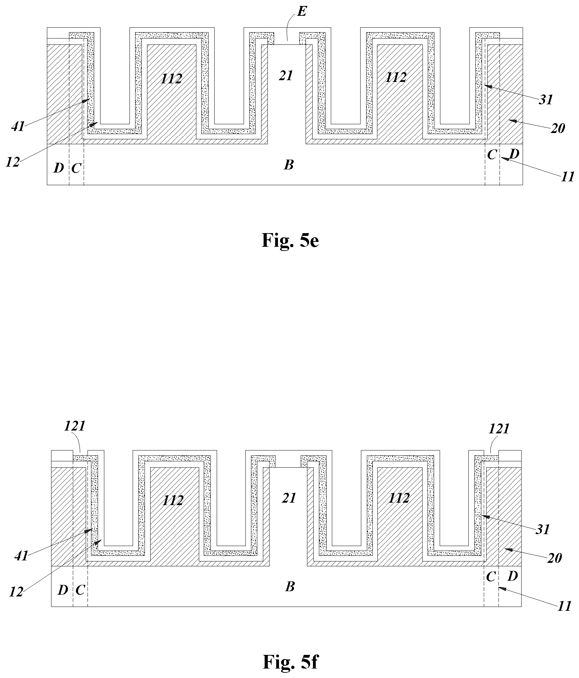

Referring to Fig.5e, a second conductive layer 12 is formed by LPCVD on the first dielectric layer 41, in the first window 311 and in the space E of the non-passivation region 21. The second conductive layer 12 is preferably a polycrystalline silicon layer. Alternatively, the second conductive layer 12 is a TiN layer, which can be obtained by ALD deposition. The second conductive layer 12 is connected to the substrate 11 through the space E to form the first electrode layer.

It will be appreciated that in the process of forming the second conductive layer 12, a conductive material is deposited in the second window 411 of the first dielectric layer 41. This conductive material may be used as a medium for connecting the first conductive layer 31 and the third conductive layer 32 in subsequent steps.

Referring to Fig.5f, a third window 121 is formed by opening holes at the first surface 11a at an edge of the substrate 11 through a reactive ion etching (RIE) of the second conductive layer 12. The third window 121 is disposed within the area enclosed by the second window 411. Preferably, the third window 121 is located within the second region C of the substrate 11. The third window 121 exposes a portion of the first dielectric layer 41.

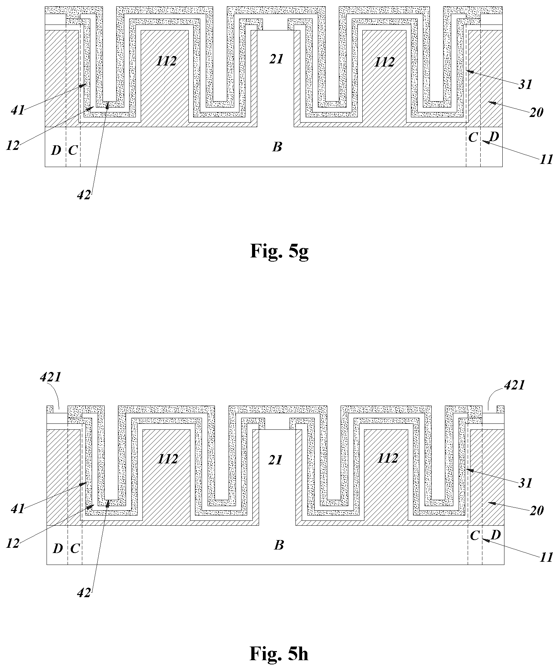

Referring to Fig.5g, a second dielectric layer 42 is deposited by LPCVD or ALD on the surface of the second conductive layer 12 and within the third window 121. The material of the second dielectric layer 42 may be SiN, SiO₂, ONO, or high K material. The second dielectric layer 42 is connected to the first dielectric layer 41 through the third window 121 to isolate the first conductive layer 31 from the second conductive layer 12, as well as to isolate the second conductive layer 12 from the conductive material within the second window 411, thereby allowing the conductive material within the first conductive layer 31 and the second window 411 to be used as a portion of the second electrode layer and the second conductive layer 12 to be used as a portion of the first electrode layer.

Referring to Fig.5h, a fourth window 421 corresponding to the second window 411 is opened on the second dielectric layer 42 by reactive ion etching (RIE). The fourth window 421 is likewise located at the first surface 11a at the edge of the substrate 11, and, preferably, is located within the third region D of the substrate 11. The fourth window 421 exposes part or all the conductive material within the second window 411.

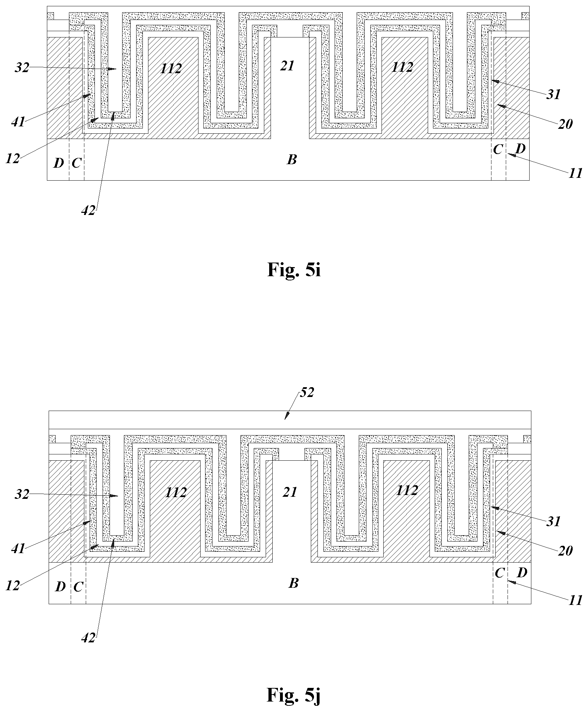

Referring to Fig.5i, a third conductive layer 32 is formed by LPCVD growth on the surface of the second dielectric layer 42 and within the fourth window 421. The third conductive layer 32 is preferably a polysilicon layer. Alternatively, the third conductive layer 32 can be obtained by ALD deposition. the third conductive layer 32 is a TiN layer. The third conductive layer 32 is coupled to the first conductive layer 31 via a conductive material within the second window 411 to form a second electrode layer.

Up to this step, the first electrode layer formed by connecting the second conductive layer 12 to the substrate 11 is completely isolated from the second electrode layer, which is formed by connecting the first conductive layer 31, the conductive material within the second window 411, and the third conductive layer 32.

Referring to Fig.5j, a second electrode 52 is formed on the surface of the third conductive layer 32 by means of metal deposition. The material of the second electrode 52 may be Au, Al-Cu, or AlTiNiAg, among others.

Referring to Fig.3, a first electrode 51 is formed on the surface of the substrate 11 back from the passivation regions 20 (the second surface 11b) by means of metal deposition. The material of the second electrode 51 may also be Au, Al-Cu, or AlTiNiAg, and the like.

It is to be understood that the number of the non-passivation region, the first window, the second window, the third window, and the fourth window in the present invention is preferably one for each, to minimize the consumption of surface area of the dielectric layer and the conductive layer, and to increase the contact area.

Compared to the prior art, the method for fabricating the capacitor structure of the present invention increases the contact area between the dielectric layers (the first dielectric layer, the second dielectric layer) and the first electrode layer (the second conductive layer and the substrate) as well as and the second electrode layer (the first conductive layer and the third conductive layer) by making holes in the second conductive layer, connecting the adjacent first dielectric layer and the second dielectric layer, and increasing the capacitance density.

The method for fabricating the capacitor structure of the present invention extracts only the first conductive layer and the third conductive layer as the second electrode layer, and the second conductive layer is extracted directly through the substrate to form the first electrode layer, which avoids the use of an electrode protection ring for the extraction of the first electrode layer, effectively increases the area of the second electrode, and increases the capacitance density, and optimizes the flow path of the current, which greatly reduce the ESR (equivalent series resistance) and ESL (equivalent series inductance).

The method for fabricating the capacitor structure of the present invention, in which the first electrode and the second electrode are formed on separate surfaces, which will not cause the problem of a short circuit between the electrodes during subsequent wire bonding and thus cause the device to fail.

The above is only a preferred embodiment of the present invention and is not intended to limit the present invention. For those skilled in the art, the present invention can have various modifications and changes. Any modifications, equivalent replacements, improvements, etc., made within the spirit and principles of the present invention, shall be included in the scope of protection of the present invention.

It should be understood that although this specification is described in accordance with the embodiments, not every embodiment includes only an independent technical solution. Such a description is merely for the sake of clarity, and those skilled in the art should take the specification as a whole. The technical solutions in the embodiments can also be appropriately combined to form other implementations which are comprehensible for those skilled in the art.

The foregoing detailed description is only specific illustration of possible embodiments of the present invention, rather than limiting the claimed scope of the present invention. All equivalent embodiments or changes made without departing from the technical spirit of the present invention should be included in the claimed scope of the present invention.

It is obvious to one skilled in the art that the present invention is not limited to the details of the exemplary embodiments described above, and that the present invention can be implemented in other specific forms without departing from the spirit or essential features of the present invention. Thus, the embodiments should be regarded as exemplary and nonlimiting in every respect, and the scope of the invention is defined by the appended claims rather than the description, so that all variations falling within the meaning and scope of the equivalent elements of the claims are intended to be included in the invention. Any appended notation in the claims should not be regarded as limiting the claims in question.

## Claims

1. A capacitor structure comprising a substrate (11) with passivation regions (20) arranged at intervals, as well as a first conductive layer (31), a first dielectric layer (41), a second conductive layer (12), a second dielectric layer (42) and a third conductive layer (32) formed in sequence on a surface of the substrate (11), wherein the second conductive layer (12) is connected to the substrate (11) in a non-passivation region (21) between adjacent passivation regions (20) to form a first electrode layer; the first conductive layer (31) is electrically connected to the third conductive layer (32) to form a second electrode layer; the first dielectric layer (41) is connected to the second dielectric layer (42) and contacts the passivation regions (20) to isolate the first electrode layer from the second electrode layer; a first electrode (51) is formed on a surface of the substrate (11) away from the passivation regions (20) ; and a second electrode (52) is formed on a surface of the third conductive layer (32).

2. The capacitor structure according to claim 1, wherein the substrate (11) comprises a first region (B), a second region (C) that surrounds the first region (B), and a third region (D) that surrounds the second region (C);
the non-passivation region (21) between the adjacent passivation regions (20) is located in the first region (B), the second conductive layer (12) is connected to the substrate (11) in the first region (B), the first dielectric layer (41) is in contact with the passivation regions (20) in the first region (B);
the first dielectric layer (41) is connected to the second dielectric layer (42) in the second region (C); and
the first conductive layer (31) is connected to the third conductive layer (32) in the third region (D).

3. The capacitor structure according to claim 1, wherein the substrate (11) comprises a first surface (11a) and a second surface (11b) disposed opposed to each other, wherein the passivation regions (20) extend from the first surface (11a) to the second surface (11b), the first surface (11a) is provided with a plurality of trenches (111) formed therein within the passivation regions (20), and the trenches (111) have a plurality of discrete columnar structures (112) formed by portions of the substrate (11).

4. The capacitor structure according to claim 3, wherein the first conductive layer (31), the first dielectric layer (41), the second conductive layer (12), the second dielectric layer (42) and the third conductive layer (32) cover or partially cover the first surface (11a) of the substrate (11), inner sidewalls of the trenches (111) and outer surfaces of the columnar structures (112).

5. The capacitor structure according to claim 3, wherein the first conductive layer (31) is formed on the first surface (11a) of the substrate (11), on inner sidewalls of the trenches (111), and on outer surfaces of the columnar structures (112); the first conductive layer (31) is provided with a first window (311) that corresponds to the non-passivation region (21), and the first window (311) exposes the substrate (11) in the non-passivation region (21) and a portion of the substrate (11) in the passivation regions (20).

6. The capacitor structure according to claim 5, wherein the first dielectric layer (41) is formed on a surface of the first conductive layer (31) and contacts the passivation regions (20) at the first window (311) to isolate the substrate (11) from the first conductive layer (31), wherein the first window (311) exposes a portion of the substrate (11) in the non-passivation region (21); and
wherein a second window (411) is provided in the first dielectric layer (41), and the second window (411) exposes a portion of the first conductive layer (31).

7. The capacitor structure according to claim 6, wherein the second window (411) is disposed at the first surface (11a) at an edge of the substrate (11), and the second window (411) is filled with conductive material that is connected to the first conductive layer (31).

8. The capacitor structure according to claim 6, wherein the second conductive layer (12) is formed on a surface of the first dielectric layer (41) and in the first window (311) to be in connection with the substrate (11) to form the first electrode layer, a third window (121) is provided in the second conductive layer (12), and the third window (121) exposes a portion of the first dielectric layer (41).

9. The capacitor structure according to claim 8, wherein the third window (121) is disposed at the first surface at an edge of the substrate (11) and are surrounded by the second window (411).

10. The capacitor structure according to claim 8, wherein the second dielectric layer (42) is formed on the surface of the second conductive layer (12) and is connected to the first dielectric layer (41) at the third window (121) to isolate the first conductive layer (31) from the second conductive layer (12), and a fourth window (421) corresponding to the second window (411) is provided in the second dielectric layer (42).

11. The capacitor structure according to claim 10, wherein the third conductive layer (32) is formed on a surface of the second dielectric layer (42) and in the fourth window (421), and is connected to the first conductive layer (31) via the conductive material in the second window (411) to form the second electrode layer.

12. The capacitor structure according to claim 1, wherein the substrate (11) is a heavily doped P-type substrate (11); and/or,
the passivation region (20) is a N-type diffusion region; and/or,
the first conductive layer (31) is a heavily doped N-type polycrystalline silicon layer or ALD-deposited TiN; and/or,
the first dielectric layer (41) is SiN, SiO₂, ONO or a high K material; and/or,
the second conductive layer (12) is a polycrystalline silicon layer or ALD-deposited TiN; and/or,
the second dielectric layer (42) is SiN, SiO₂, ONO or high K material; and/or,
the third conductive layer (32) is a polycrystalline silicon layer or ALD-deposited TiN.

13. A method for fabricating a capacitor structure comprising:
providing a substrate (11) which has a first surface (11a) and a second surface (11b) opposed to each other;
forming passivation regions (20) disposed at intervals on the first surface (11a) of the substrate (11); a non-passivation region (21) that exposing the substrate (11) being located between adjacent passivation regions (20);
forming trenches (111) in the passivation regions (20) of the first surface (11a), the trenches (111) having a plurality of discrete columnar structures (112) formed from portions of the substrate (11);
forming a first conductive layer (31) on the first surface (11a) of the substrate (11), on inner sidewalls of the trenches (111) and on outer surfaces of the columnar structures (112), the first conductive layer (31) exposing a portion of the substrate (11) in the non-passivation region (21) of the substrate (11);
forming a first dielectric layer (41) on a surface of the first conductive layer (31), the first dielectric layer (41) contacting the passivation region (20) in the non-passivation region (21), the first dielectric layer (41) and the first conductive layer (31) acting together to isolate the first conductive layer (31) from the substrate (11);
forming a second conductive layer (12) on a surface of the first dielectric layer (41) that is in contact with the substrate (11);
forming a second dielectric layer (42) on a surface of the second conductive layer (12) that is in contact with the first dielectric layer (41), the second dielectric layer (42) and the first dielectric layer (41) acting together to isolate the second conductive layer (12) from the first conductive layer (31);
forming a third conductive layer (32) on a surface of the second dielectric layer (42) that is in contact with the second conductive layer (12);
forming a first electrode (51) on the second surface (11b) of the substrate (11); and
forming a second electrode (52) on a surface of the third conductive layer (32).

14. The method for fabricating a capacitor structure according to claim 13, wherein a first dielectric layer (41) in contact with the passivation regions (20) is formed on the surface of the first conductive layer (31), comprising:
opening a first window (311) corresponding to the non-passivation region (21) in the first conductive layer (31), the first window (311) exposing the substrate (11) of the non-passivation region (21) and a portion of the substrate (11) of the passivation regions (20); and
forming a first dielectric layer (41) on the surface of the first conductive layer (31), the first dielectric layer (41) contacting the exposed passivation region (20) at the first window (311) to isolate the substrate (11) from the first conductive layer (31).

15. The method for fabricating a capacitor structure according to claim 14, further comprising:
opening a second window (411) in the first dielectric layer (41), and the second window (411) exposing portions of the first conductive layer (31); and
forming a second conductive layer (12) on the surface of the first dielectric layer (41) and in the first window (311) to connect the substrate (11).

16. The method for fabricating a capacitor structure according to claim 15, further comprising:
opening a third window (121) in the second conductive layer (12), and the third window (121) exposing portions of the first dielectric layer (41); and
forming a second dielectric layer (42) on the surface of the second conductive layer (12) and in the third window (121), which is connected to the first dielectric layer (41), to isolate the first conductive layer (31) from the second conductive layer (12).

17. The method for fabricating a capacitor structure according to claim 16, further comprising:
opening a fourth window (421) corresponding to the second window (411) in the second dielectric layer (42); and
forming a third conductive layer (32) on the surface of the second dielectric layer (42) and in the fourth window (421), and the third conductive layer (32) being connected to the first conductive layer (31) via the conductive material in the second window (411).

18. The method for fabricating a capacitor structure according to claim 17, wherein the non-passivation region (21) is located in the middle of the substrate (11) and is surrounded by the second window (411) and third window (121);
the second window (411) is located at the first surface (11a) at an edge of the substrate (11); and
the third window is located at the first surface (11a) at the edge of the substrate (11) and is surrounded by the second window (411).
